# DEMANDE DE BREVET EUROPEEN

(11) **EP 3 573 231 A1**
(43) Date de publication de la demande: **27.11.2019**
(21) Numéro de dépôt: 19174027.3
(22) Date de dépôt: 13.05.2019
(51) Int. Cl.: H03D 3/02, H03M 1/06, H04L 12/26, H04L 12/24

(54) **DISPOSITIF ET PROCÉDÉ DE SURVEILLANCE ET DE CALIBRATION D'UN SYSTÈME D' ACQUISITION DE DONNÉES ET/OU DE TRANSMISSION DE DONNÉES**

(30) Priorité: 23.05.2018 FR 1854293
(71) Demandeur: Airbus Opérations SAS, 31060 Toulouse (FR)
(72) Inventeur: PASQUIER, Michel, 32130 SAVIGNAC-MONA (FR); CROYET, Roland, 31400 TOULOUSE (FR)
(74) Mandataire: Gevers & Orès

(57) **Abrégé**

- Dispositif et procédé de surveillance et de calibration d'un système d'acquisition de données et/ou de transmission de données.
- Le dispositif de surveillance (1) permet de surveiller le fonctionnement d'un système d'acquisition et/ou de transmission (2) par des moyens simples et peu encombrants. Le dispositif de surveillance (1) comprend un module de génération de signal modèle de surveillance (3), un module de génération de signaux modèles de calibration (12), un module mélangeur (4) d'un signal d'entrée (S2) avec le signal modèle de surveillance (S1) et les signaux modèles de calibration (S6, S7), un module de reconnaissance (7) configuré pour reconnaître le signal modèle de surveillance (S1), au moins un module de calcul (13) pour calculer au moins une erreur de décalage et au moins une erreur de gain, un module de transmission (8) d'un signal de bon fonctionnement ou de fonctionnement défectueux à un dispositif utilisateur (9) selon que le signal modèle de surveillance (S1) est reconnu ou non reconnu par le module de reconnaissance (7) et un module de transmission (14) d'un signal représentatif de l'erreur de décalage (S8) et d'un signal représentatif de l'erreur de gain (S9).

## Description

### DOMAINE TECHNIQUE

La présente invention concerne le domaine de l'acquisition et de la transmission de données. En particulier, elle concerne un dispositif permettant de surveiller la bonne connexion, le bon fonctionnement d'un système d'acquisition et/ou de transmission de données. Le dispositif permet également de vérifier la bonne calibration du système d'acquisition et/ou de transmission.

### ÉTAT DE LA TECHNIQUE

Dans le domaine de l'acquisition et de la transmission de données, les systèmes d'acquisition et/ou de transmission de données, tels que les concentrateurs de données (« data concentrators » en anglais) et les cartes d'entrée ou de sortie électroniques (« input or output boards » en anglais), jouent des rôles importants. En effet, les systèmes électroniques traitent des quantités de données très importantes, ce qui amène ces systèmes électroniques à utiliser de grandes quantités de données et à transmettre de grandes quantités de données.

Pour les systèmes avioniques, notamment, la surveillance du signal d'entrée d'un système présente un aspect important pour la sécurité. De grands nombres de tests sont usuellement réalisés pendant la phase d'autotest au démarrage (« power on self-test » en anglais) en utilisant des systèmes électroniques de test intégrés très encombrants. De plus, ces systèmes électroniques de test doivent également être surveillés. Ces tests durent longtemps et réduisent la quantité de cartes électroniques disponibles pour l'intégration de fonctions.

### EXPOSÉ DE L'INVENTION

La présente invention a pour objet de pallier ces inconvénients en proposant un dispositif de surveillance d'un système d'acquisition et/ou de transmission de données.

À cet effet, l'invention concerne un dispositif de surveillance d'un système d'acquisition de données destiné à alimenter en données un système électrique et/ou d'un système de transmission de données destiné à émettre des données provenant d'un système électrique, le système d'acquisition et/ou de transmission étant configuré pour être alimenté par un signal d'entrée et pour émettre un signal de sortie, le signal de sortie étant lié au signal d'entrée par une fonction de transfert propre au système d'acquisition et/ou de transmission.

Selon l'invention, le dispositif de surveillance comprend :
- au moins un module de génération de signal de surveillance, configuré pour générer un signal modèle de surveillance ;
- au moins un module de génération de signal de calibration, configuré pour générer au moins deux signaux modèles de calibration,
- au moins un module mélangeur, configuré pour mélanger au moins le signal d'entrée avec le signal modèle de surveillance et les au moins deux signaux modèles de calibration afin d'obtenir un signal mélangé ;
- au moins un module d'alimentation, configuré pour alimenter le système d'acquisition et/ou de transmission par le signal mélangé ;
- au moins un module de réception, configuré pour recevoir un signal de sortie mélangé émis par le système d'acquisition et/ou de transmission alimenté par le signal mélangé ;
- un module de reconnaissance, configuré pour reconnaître le signal modèle de surveillance dans le signal de sortie mélangé ;
- au moins un module de calcul, configuré pour calculer au moins une erreur de décalage et au moins une erreur de gain à partir de la fonction de transfert propre au système d'acquisition et/ou de transmission et du signal de sortie mélangé émis par le système d'acquisition et/ou de transmission alimenté par le signal mélangé ;
- un premier module de transmission, configuré pour transmettre à un dispositif utilisateur, alternativement :
   ∘ un signal représentatif d'un bon fonctionnement, si le module de reconnaissance reconnaît le signal modèle de surveillance, ou
   ∘ un signal représentatif d'un fonctionnement défectueux, si le module de reconnaissance ne reconnaît pas le signal modèle de surveillance ;
- un deuxième module de transmission, configuré pour transmettre au dispositif utilisateur un signal représentatif de l'erreur de décalage et un signal représentatif de l'erreur de gain.

Ainsi, grâce à l'invention, un système d'acquisition et/ou de transmission peut être surveillé sans nécessiter de moyens encombrants et complexes à mettre en place. Le module de reconnaissance permet de s'assurer que le signal modèle de surveillance est bien présent dans le signal sortant du système d'acquisition et/ou de transmission alimenté par le signal mélangé. Le module de calcul permet de s'assurer de la bonne calibration du système d'acquisition et/ou de transmission.

De plus, le signal modèle de surveillance possède au moins une des propriétés suivantes :
- le signal modèle de surveillance présente une énergie inférieure à une énergie maximale prédéterminée par le système d'acquisition et/ou de transmission ;
- le signal modèle de surveillance présente une plage de fréquences différente d'une plage de fréquences prédéterminée par le système d'acquisition et/ou de transmission ;
- le signal modèle de surveillance présente une forme de fonction d'autocorrélation quasi-Dirac.

En outre, le signal modèle de surveillance correspond à un signal à modulation de fréquence.

Par ailleurs, les signaux modèles de calibration correspondent à des signaux alternatifs.

Selon une particularité, le module de reconnaissance est configuré pour calculer une corrélation croisée entre le signal de sortie mélangé et le signal modèle de surveillance, et en fonction de ce calcul :
- le module de reconnaissance génère un signal de bon fonctionnement si la corrélation croisée est supérieure à un seuil prédéterminé,
- le module de reconnaissance génère un signal de fonctionnement défectueux si la corrélation croisée est inférieure ou égale au seuil prédéterminé.

Selon une autre particularité, le dispositif de surveillance comprend en outre :
- un module d'acquisition configuré pour acquérir le signal de sortie lié au signal d'entrée par la fonction de transfert propre au système d'acquisition et/ou de transmission à partir du signal de sortie mélangé ;
- un troisième module de transmission, configuré pour transmettre au dispositif utilisateur le signal de sortie acquis par le module d'acquisition.

L'invention concerne également un procédé de surveillance d'un système d'acquisition de données destiné à alimenter en données un système électrique et/ou d'un système de transmission de données destiné à émettre des données provenant d'un système électrique, le système d'acquisition et/ou de transmission étant configuré pour être alimenté par un signal d'entrée et pour émettre un signal de sortie, le signal de sortie étant lié au signal d'entrée par une fonction de transfert propre au système d'acquisition et/ou de transmission.

Selon l'invention, le procédé de surveillance comprend les étapes suivantes :
- une étape de génération de signal de surveillance, mise en oeuvre par au moins un module de génération de signal de surveillance, consistant à générer un signal modèle de surveillance ;
- une étape de génération de signal de calibration, mise en oeuvre par au moins un module de génération de signal de calibration, consistant à générer au moins deux signaux modèles de calibration ;
- une étape de mélange, mise en oeuvre par au moins un module mélangeur, consistant à mélanger au moins le signal d'entrée avec le signal modèle de surveillance et les au moins deux signaux modèles de calibration afin d'obtenir un signal mélangé ;
- une étape d'alimentation, mise en oeuvre par au moins un module d'alimentation, consistant à alimenter le système d'acquisition et/ou de transmission par le signal mélangé ;
- une étape de réception, mise en oeuvre par au moins un module de réception, consistant à recevoir un signal de sortie mélangé émis par le système d'acquisition et/ou de transmission alimenté par le signal mélangé ;
- une étape de reconnaissance, mise en oeuvre par un module de reconnaissance, consistant à reconnaître le signal modèle de surveillance dans le signal de sortie mélangé ;
- une étape de calcul, mise en oeuvre par au moins un module de calcul, consistant à calculer au moins une erreur de décalage et au moins une erreur de gain à partir de la fonction de transfert du système d'acquisition et/ou de transmission et du signal de sortie mélangé émis par le d'acquisition et/ou de transmission alimenté par le signal mélangé ;
- une première étape de transmission, mise en oeuvre par un premier module de transmission, consistant à transmettre à un dispositif utilisateur, alternativement :
   ∘ un signal représentatif d'un bon fonctionnement, si le signal modèle de surveillance est reconnu dans l'étape de reconnaissance, ou,
   ∘ un signal représentatif d'un fonctionnement défectueux, si le signal modèle de surveillance n'est pas reconnu dans l'étape de reconnaissance ;
- une deuxième étape de transmission, mise en oeuvre par un deuxième module de transmission, consistant à transmettre au dispositif utilisateur un signal représentatif de l'erreur de décalage et un signal représentatif de l'erreur de gain.

Selon une particularité, le procédé comprend en outre :
- une étape d'acquisition, mise en oeuvre par un module d'acquisition, consistant à acquérir le signal de sortie lié au signal d'entrée par la fonction de transfert propre au système d'acquisition et/ou de transmission à partir du signal de sortie mélangé ;
- une troisième étape de transmission, mise en oeuvre par un troisième module de transmission, consistant à transmettre le signal de sortie acquis lors de l'étape d'acquisition.

### BRÈVE DESCRIPTION DES FIGURES

L'invention, avec ses caractéristiques et avantages, ressortira plus clairement à la lecture de la description faite en référence aux dessins annexés dans lesquels :
- la figure 1 représente schématiquement le dispositif de surveillance selon un premier mode de réalisation,
- la figure 2 représente schématiquement le dispositif de surveillance selon une première variante d'un deuxième mode de réalisation,
- la figure 3 représente schématiquement le dispositif de surveillance selon une deuxième variante du deuxième mode de réalisation,
- la figure 4 représente schématiquement les étapes du procédé de surveillance.

### DESCRIPTION DÉTAILLÉE

La suite de la description fera référence aux figures citées ci-dessus.

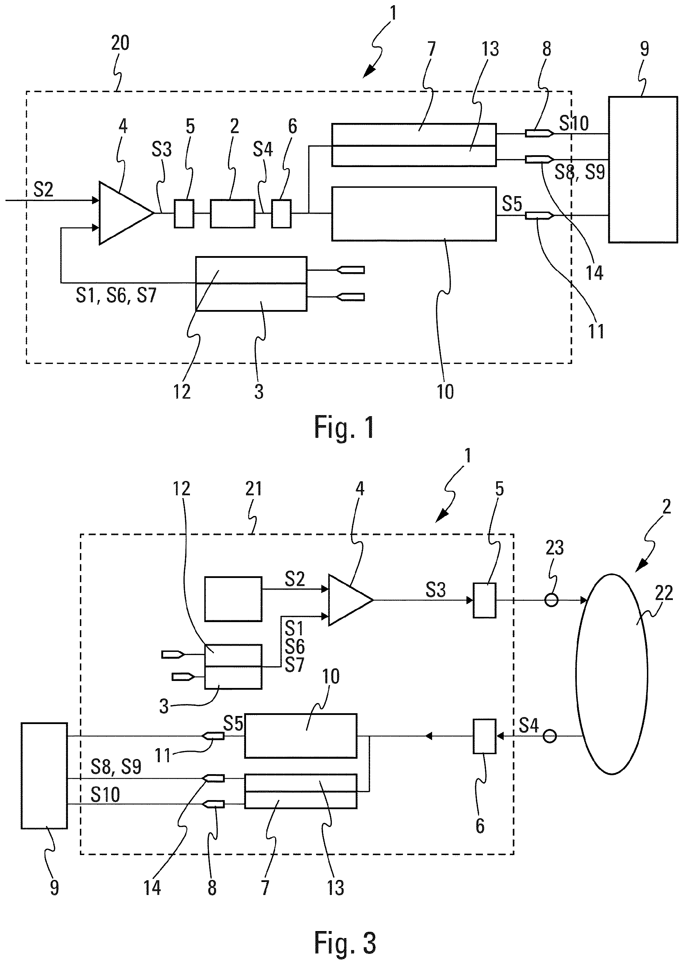

L'invention concerne un dispositif de surveillance 1 destiné à surveiller un système d'acquisition de données 2 (« système d'acquisition 2 » ci-après) destiné à alimenter en données un système électrique et/ou d'un système de transmission de données 2 (« système de transmission 2 » ci-après) destiné à émettre des données provenant d'un système électrique (figures 1, 2 et 3).

Le système d'acquisition 2 et/ou le système de transmission 2 correspondent, par exemple, à un concentrateur de données ou à une carte d'entrée ou de sortie électronique. Il peut comprendre, par exemple, des circuits de conversion analogique-numérique ou des circuits de conversion numérique-analogique.

Le système d'acquisition et/ou de transmission 2 est configuré pour être alimenté par un signal d'entrée S2 et pour émettre un signal de sortie S5.

Le signal de sortie du système d'acquisition 2 peut correspondre au signal qui alimente le système électrique.

Le signal de sortie S5 est lié au signal d'entrée S2 par une fonction de transfert propre au système d'acquisition et/ou de transmission 2. Généralement, la fonction de transfert correspond à une représentation mathématique d'une relation entre la transformée de Laplace du signal d'entrée S2 et la transformée de Laplace du signal de sortie S5 d'un système linéaire invariant ou variant très lentement dans le temps. Les variations du système linéaires peuvent être dues aux conditions environnementales.

Le dispositif de surveillance 1 comprend au moins un module de génération de signal de surveillance 3, configuré pour générer un signal modèle de surveillance S1. Le module de génération de signal de surveillance 3 peut également générer plusieurs signaux modèles de surveillance S1.

Avantageusement, le signal modèle de surveillance S1 présente au moins une énergie inférieure à une énergie maximale prédéterminée par le système d'acquisition et/ou de transmission 2. L'énergie maximale prédéterminée correspond à l'énergie maximale que le signal modèle de surveillance S1 peut présenter sans qu'il ne soit bloqué par le système d'acquisition et/ou de transmission 2 et sans qu'il ne perturbe la dynamique du signal d'entrée S2.

De même, le signal modèle de surveillance S1 peut aussi présenter une plage de fréquences différente d'une plage de fréquences prédéterminée par le système d'acquisition et/ou de transmission 2. La plage de fréquences prédéterminée correspond à la plage de fréquences de fonctionnement du système d'acquisition et/ou de transmission 2. Ainsi, le signal modèle de surveillance S1 présente une plage de fréquences qui permet d'éviter les interférences avec la plage de fréquences de fonctionnement du système d'acquisition et/ou de transmission 2.

En outre, le signal modèle de surveillance S1 peut présenter une forme de fonction d'autocorrélation quasi-Dirac.

Le signal modèle de surveillance S1 peut correspondre à un signal à modulation de fréquence ou autrement appelé « signal chirp ». Un signal chirp correspond, par exemple, à un signal pseudopériodique, modulé en fréquence autour d'une fréquence porteuse et également modulé en amplitude par une enveloppe dont les variations sont lentes par rapport aux oscillations de la phase.

Le dispositif de surveillance 1 comprend en outre au moins un module de génération de signal de calibration 12, configuré pour générer au moins deux signaux modèles de calibration S6, S7.

Le dispositif de surveillance 1 comprend également au moins un module mélangeur 4 configuré pour mélanger au moins le signal d'entrée S2 avec le signal modèle de surveillance S1 et les au moins deux signaux modèles de calibration S6, S7 afin d'obtenir un premier signal mélangé S3.

Le module mélangeur 4 peut être configuré pour additionner au moins le signal d'entrée S2, le signal modèle de surveillance S1, un signal modèle de calibration S6 et un signal modèle de calibration S7. Le signal mélangé S3 correspond alors à la somme au moins du signal d'entrée S2, du signal modèle de surveillance S1, du signal modèle de calibration S6 et du signal modèle de calibration S7.

Le dispositif de surveillance 1 comprend en outre :
- au moins un module d'alimentation 5, configuré pour alimenter le système d'acquisition et/ou de transmission 2 par le signal mélangé S3 ;
- au moins un module de réception 6, configuré pour recevoir un signal de sortie mélangé S4 émis par le système d'acquisition et/ou de transmission 2 alimenté par le signal mélangé S3.

Le dispositif de surveillance 1 comprend aussi un module de reconnaissance 7, configuré pour reconnaître le signal modèle de surveillance S1 dans le signal de sortie mélangé S4.

Par exemple un signal possède des caractéristiques spécifiques. La reconnaissance de ce signal peut revenir à retrouver ces caractéristiques spécifiques dans un signal donné.

Le dispositif de surveillance 1 comprend également au moins un module de calcul 13, configuré pour calculer au moins une erreur de décalage et au moins une erreur de gain à partir de la fonction de transfert propre au système d'acquisition et/ou de transmission 2 et du signal de sortie mélangé S4 émis par le système d'acquisition et/ou de transmission 2 alimenté par le signal mélangé S3.

Le dispositif de surveillance 1 comprend aussi un module de transmission 8 et un module de transmission 14

Le module de transmission 8 est configuré pour transmettre à un dispositif utilisateur 9, alternativement :
∘ un signal représentatif d'un bon fonctionnement S10, si le module de reconnaissance 7 reconnaît le signal modèle de surveillance S1, ou,
∘ un signal représentatif d'un fonctionnement défectueux S10, si le module de reconnaissance 7 ne reconnaît pas le signal modèle de surveillance S1.

Le module de transmission 14 est configuré pour transmettre au dispositif utilisateur 9 un signal représentatif de l'erreur de décalage S8 et un signal représentatif de l'erreur de gain S9.

Le dispositif utilisateur 9 peut comprendre un écran d'affichage qui affiche un symbole ou une expression indiquant le bon fonctionnement du système d'acquisition et/ou de transmission 2 si le signal S10 reçu par le dispositif utilisateur 9 correspond à un signal représentatif d'un bon fonctionnement S10. Un autre symbole ou une autre expression peut être affiché sur l'écran d'affichage si le signal S10 reçu par le dispositif utilisateur 9 correspond à un signal représentatif d'un fonctionnement défectueux S10.

Le dispositif de surveillance 1 peut comprendre également :
- un module d'acquisition 10 configuré pour acquérir le signal de sortie S5 lié au signal d'entrée S2 par la fonction de transfert propre au système d'acquisition et/ou de transmission 2 à partir du signal de sortie mélangé S4 ;
- un module de transmission 11, configuré pour transmettre au dispositif utilisateur 9 le signal de sortie S5 acquis par le module d'acquisition 10.

Le signal de sortie S5 acquis par le module d'acquisition 10 permet d'alimenter le système électrique ou de transmettre le signal provenant du système électrique.

Avantageusement, le module de reconnaissance 7 est configuré pour calculer une corrélation croisée entre le signal de sortie mélangé S4 et le signal modèle de surveillance S1. Le module de reconnaissance 7 génère un signal de bon fonctionnement S10 si la corrélation croisée est sensiblement supérieure à un seuil prédéterminé. Dans ce cas, cela signifie que le résultat de la corrélation croisée présente une valeur significative indiquant la présence du signal modèle de surveillance S1. Le module de reconnaissance 7 génère un signal de fonctionnement défectueux S10 si la corrélation croisée est sensiblement inférieure ou égale au seuil prédéterminé.

Les signaux modèles de calibration S8, S9 correspondent, par exemple, à des signaux alternatifs.

De préférence, pour calibrer le système d'acquisition et/ou de transmission 2, le ou les modules de génération de signal de surveillance 3 ne génèrent pas de signal modèle de surveillance S1 quand le ou les modules de génération de signal de calibration 12 génèrent les signaux modèles de calibration S6, S7.

Le module de calcul 13 permet de déterminer au moins une erreur de décalage et au moins une erreur de gain à partir d'un système de deux équations à deux inconnues grâce aux deux signaux modèles de calibration S6 et S7. Les inconnues du système d'équations correspondent à l'erreur de décalage et à l'erreur de gain.

La figure 1 représente le dispositif de surveillance 1 selon un premier mode de réalisation. Dans ce mode de réalisation, le dispositif de surveillance 1 est intégré dans une unité 20 comprenant le système d'acquisition et/ou de transmission 2. Par exemple, le dispositif de surveillance 1 et le système d'acquisition et/ou de transmission 2 sont compris sur une même carte électronique.

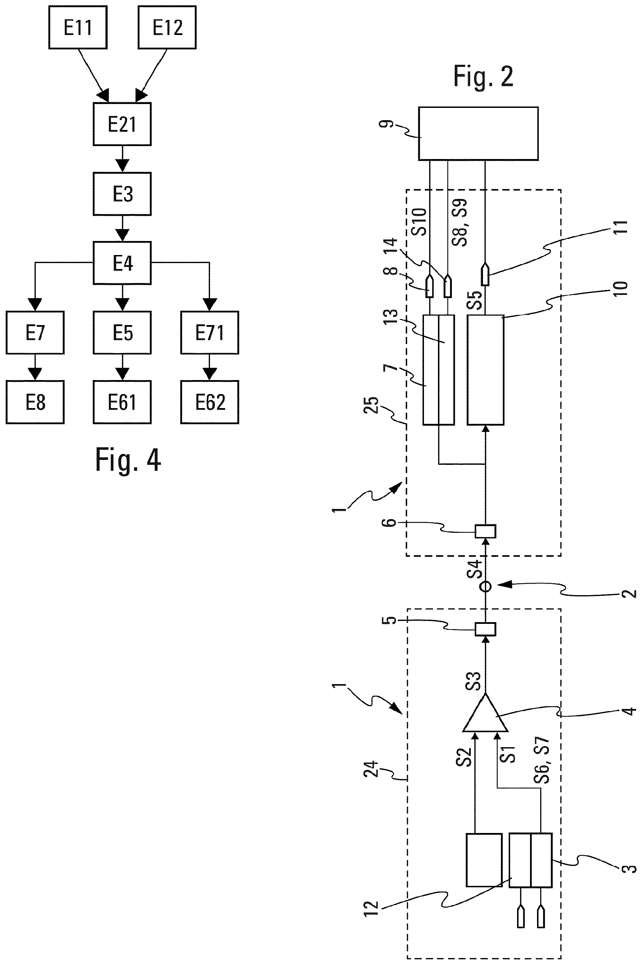

La figure 2 représente le dispositif de surveillance 1 selon une première variante d'un deuxième mode de réalisation. Dans cette variante, le dispositif de surveillance 1 est réparti dans deux dispositifs électroniques 24, 25 séparés du système d'acquisition et/ou de transmission 2. Un premier dispositif 24 permet le mélange du signal d'entrée S2 avec le signal modèle de surveillance S1 et les au moins deux signaux modèles de calibration S6, S7 pour alimenter le système d'acquisition et/ou de transmission 2. Un deuxième dispositif électronique 25 permet la reconnaissance du signal modèle de surveillance S1 et la détermination de l'erreur de décalage et de l'erreur de gain. Par exemple, le premier dispositif 24 est compris sur une première carte électronique et le deuxième dispositif 25 est compris sur une deuxième carte électronique.

La figure 3 représente le dispositif de surveillance 1 selon une deuxième variante du deuxième mode de réalisation. Dans cette variante, le dispositif de surveillance 1 est contenu dans un dispositif électronique 21 séparé du système d'acquisition et/ou de transmission 2. Par exemple, ce dispositif de surveillance 1 permet une surveillance en continu, dans un mode de fonctionnement en boucle fonctionnelle, d'un capteur 22, d'un câblage 23 et de circuits de conversion analogique-numérique et/ou de conversion numérique-analogique.

L'invention concerne également un procédé de surveillance d'un système d'acquisition de données destiné à alimenter en données un système électrique et/ou d'un système de transmission de données destiné à émettre des données provenant d'un système électrique.

Le procédé de surveillance comprend les étapes suivantes :
- une étape E11 de génération de signal de surveillance, mise en oeuvre par le ou les modules de génération de signal de surveillance 3, consistant à générer un signal modèle de surveillance S1 ;
- une étape E12 de génération de signal de calibration, mise en oeuvre par au moins un module de génération de signal de calibration 12, consistant à générer au moins deux signaux modèles de calibration S6, S7,
- une étape E21 de mélange, mise en oeuvre par le ou les premiers modules mélangeurs 4, consistant à mélanger au moins le signal d'entrée S2 avec le signal modèle de surveillance S1 et les au moins deux signaux modèles de calibration S6, S7 afin d'obtenir un signal mélangé S3 ;
- une étape E3 d'alimentation, mise en oeuvre par le ou les modules d'alimentation 5, consistant à alimenter le système d'acquisition et/ou de transmission 2 par le signal mélangé S3 ;
- une étape E4 de réception, mise en oeuvre par le ou les modules de réception 6, consistant à recevoir un signal de sortie mélangé S4 émis par le système d'acquisition et/ou de transmission 2 alimenté par le signal mélangé S3 ;
- une étape E5 de reconnaissance, mise en oeuvre par le module de reconnaissance 7, consistant à reconnaître le signal modèle de surveillance S1 dans le signal de sortie mélangé S4 ;
- une étape E71 de calcul, mise en oeuvre par le ou les modules de calcul 13, consistant à calculer au moins une erreur de décalage et au moins une erreur de gain à partir de la fonction de transfert du système d'acquisition et/ou de transmission 2 et du signal de sortie mélangé S4 émis par le d'acquisition et/ou de transmission 2 alimenté par le signal mélangé S3, ;
- une étape E61 de transmission, mise en oeuvre par le module de transmission 8, consistant à transmettre au dispositif utilisateur 9, alternativement :
   ∘ un signal représentatif d'un bon fonctionnement S10, si le signal modèle de surveillance S1 est reconnu dans l'étape E5 de reconnaissance, ou,
   ∘ un signal représentatif d'un fonctionnement défectueux S10, si le signal modèle de surveillance S1 n'est pas reconnu dans l'étape E5 de reconnaissance ;
- une étape E62 de transmission, mise en oeuvre par le module de transmission 14, consistant à transmettre au dispositif utilisateur 9 un signal représentatif de l'erreur de décalage S8 et un signal représentatif de l'erreur de gain S9.

Le procédé de surveillance peut également comprendre les étapes suivantes :
- une étape E7 d'acquisition, mise en oeuvre par le module d'acquisition 10, consistant à acquérir le signal de sortie S5 lié au signal d'entrée S2 par la fonction de transfert propre au système d'acquisition et/ou de transmission 2 à partir du signal de sortie mélangé S4 ;
- une étape E8 de transmission, mise en oeuvre par le module de transmission 11, consistant à transmettre au dispositif utilisateur 9 le signal de sortie S5 acquis lors de l'étape E7 d'acquisition.

## Revendications

1. Dispositif de surveillance d'un système d'acquisition de données destiné à alimenter en données un système électrique et/ou d'un système de transmission de données destiné à émettre des données provenant d'un système électrique, le système d'acquisition et/ou de transmission (2) étant configuré pour être alimenté par un signal d'entrée (S2) et pour émettre un signal de sortie, le signal de sortie (S5) étant lié au signal d'entrée (S2) par une fonction de transfert propre au système d'acquisition et/ou de transmission (2),
**caractérisé en ce qu'**il comprend :
- au moins un module de génération de signal de surveillance (3), configuré pour générer un signal modèle de surveillance (S1) ;
- au moins un module de génération de signal de calibration (12), configuré pour générer au moins deux signaux modèles de calibration (S6, S7),
- au moins un module mélangeur (4), configuré pour mélanger au moins le signal d'entrée (S2) avec le signal modèle de surveillance (S1) et les au moins deux signaux modèles de calibration (S6, S7) afin d'obtenir un signal mélangé (S3) ;
- au moins un module d'alimentation (5), configuré pour alimenter le système d'acquisition et/ou de transmission (2) par le signal mélangé (S3) ;
- au moins un module de réception (6), configuré pour recevoir un signal de sortie mélangé (S4) émis par le système d'acquisition et/ou de transmission (2) alimenté par le signal mélangé (S3) ;
- un module de reconnaissance (7), configuré pour reconnaître le signal modèle de surveillance (S1) dans le signal de sortie mélangé (S4) ;
- au moins un module de calcul (13), configuré pour calculer au moins une erreur de décalage et au moins une erreur de gain à partir de la fonction de transfert propre au système d'acquisition et/ou de transmission (2) et du signal de sortie mélangé (S4) émis par le système d'acquisition et/ou de transmission (2) alimenté par le signal mélangé (S3) ;
- un premier module de transmission (8), configuré pour transmettre à un dispositif utilisateur (9), alternativement :
∘ un signal représentatif d'un bon fonctionnement (S10), si le module de reconnaissance (7) reconnaît le signal modèle de surveillance (S1), ou,
∘ un signal représentatif d'un fonctionnement défectueux (S10), si le module de reconnaissance (7) ne reconnaît pas le signal modèle de surveillance (S1) ;
- un deuxième module de transmission (14), configuré pour transmettre au dispositif utilisateur (9) un signal représentatif de l'erreur de décalage (S8) et un signal représentatif de l'erreur de gain (S9).

2. Dispositif selon la revendication 1,
**caractérisé en ce que** le signal modèle de surveillance (S1) possède au moins une des propriétés suivantes :
- le signal modèle de surveillance (S1) présente une énergie inférieure à une énergie maximale prédéterminée par le système d'acquisition et/ou de transmission (2) ;
- le signal modèle de surveillance (S1) présente une plage de fréquences différente d'une plage de fréquences prédéterminée par le système d'acquisition et/ou de transmission (2) ;
- le signal modèle de surveillance (S1) présente une forme de fonction d'autocorrélation quasi-Dirac.

3. Dispositif selon l'une quelconque des revendications 1 ou 2, **caractérisé en ce que** le signal modèle de surveillance (S1) correspond à un signal à modulation de fréquence.

4. Dispositif selon l'une quelconque des revendications 1 à 3, **caractérisé en ce que** les signaux modèles de calibration (S6, S7) correspondent à des signaux alternatifs.

5. Dispositif selon l'une quelconque des revendications 1 à 4,
**caractérisé en ce que** le module de reconnaissance (7) est configuré pour calculer une corrélation croisée entre le signal de sortie mélangé (S4) et le signal modèle de surveillance (S1), et en fonction de ce calcul :
- le module de reconnaissance (7) génère un signal de bon fonctionnement (S10) si la corrélation croisée est supérieure à un seuil prédéterminé,
- le module de reconnaissance (7) génère un signal de fonctionnement défectueux (S10) si la corrélation croisée est inférieure ou égale au seuil prédéterminé.

6. Dispositif selon l'une quelconque des revendications 1 à 5,
**caractérisé en ce qu'**il comprend en outre :
- un module d'acquisition (10) configuré pour acquérir le signal de sortie (S5) lié au signal d'entrée (S2) par la fonction de transfert propre au système d'acquisition et/ou de transmission (2) à partir du signal de sortie mélangé (S4) ;
- un troisième module de transmission (11), configuré pour transmettre au dispositif utilisateur (9) le signal de sortie (S5) acquis par le module d'acquisition (10).

7. Procédé de surveillance d'un système d'acquisition de données destiné à alimenter en données un système électrique et/ou d'un système de transmission de données destiné à émettre des données provenant d'un système électrique, le système d'acquisition et/ou de transmission (2) étant configuré pour être alimenté par un signal d'entrée (S2) et pour émettre un signal de sortie (S5), le signal de sortie (S5) étant lié au signal d'entrée (S2) par une fonction de transfert propre au système d'acquisition et/ou de transmission (2),
**caractérisé en ce qu'**il comprend les étapes suivantes :
- une étape (E11) de génération de signal de surveillance, mise en oeuvre par au moins un module de génération de signal de surveillance (3), consistant à générer un signal modèle de surveillance (S1) ;
- une étape (E12) de génération de signal de calibration, mise en oeuvre par au moins un module de génération de signal de calibration (12), consistant à générer au moins deux signaux modèles de calibration (S6, S7) ;
- une étape (E21) de mélange, mise en oeuvre par au moins un module mélangeur (4), consistant à mélanger au moins le signal d'entrée (S2) avec le signal modèle de surveillance (S1) et les au moins deux signaux modèles de calibration (S6, S7) afin d'obtenir un signal mélangé (S3) ;
- une étape (E3) d'alimentation, mise en oeuvre par au moins un module d'alimentation (5), consistant à alimenter le système d'acquisition et/ou de transmission (2) par le signal mélangé (S3) ;
- une étape (E4) de réception, mise en oeuvre par au moins un module de réception (6), consistant à recevoir un signal de sortie mélangé (S4) émis par le système d'acquisition et/ou de transmission (2) alimenté par le signal mélangé (S3) ;
- une étape (E5) de reconnaissance, mise en oeuvre par un module de reconnaissance (7), consistant à reconnaître le signal modèle de surveillance (S1) dans le signal de sortie mélangé (S4) ;
- une étape (E71) de calcul, mise en oeuvre par au moins un module de calcul (13), consistant à calculer au moins une erreur de décalage et au moins une erreur de gain à partir de la fonction de transfert du système d'acquisition et/ou de transmission (2) et du signal de sortie mélangé (S4) émis par le d'acquisition et/ou de transmission (2) alimenté par le signal mélangé (S3) ;
- une première étape (E61) de transmission, mise en oeuvre par un premier module de transmission (8), consistant à transmettre à un dispositif utilisateur (9), alternativement :
∘ un signal représentatif d'un bon fonctionnement (S10), si le signal modèle de surveillance (S1) est reconnu dans l'étape (E5) de reconnaissance, ou,
∘ un signal représentatif d'un fonctionnement défectueux (S10), si le signal modèle de surveillance (S1) n'est pas reconnu dans l'étape (E5) de reconnaissance ;
- une deuxième étape (E62) de transmission, mise en oeuvre par un deuxième module de transmission (14), consistant à transmettre au dispositif utilisateur (9) un signal représentatif de l'erreur de décalage (S8) et un signal représentatif de l'erreur de gain (S9).

8. Procédé selon la revendication 7,
**caractérisé en ce qu'**il comprend en outre :
- une étape (E7) d'acquisition, mise en oeuvre par un module d'acquisition (10), consistant à acquérir le signal de sortie (S5) lié au signal d'entrée (S2) par la fonction de transfert propre au système d'acquisition et/ou de transmission (2) à partir du signal de sortie mélangé (S4) ;
- une troisième étape (E8) de transmission, mise en oeuvre par un troisième module de transmission (11), consistant à transmettre le signal de sortie (S5) acquis lors de l'étape (E7) d'acquisition.
